# EUROPEAN PATENT SPECIFICATION

(11) **EP 0 863 554 B1**
(45) Date of publication and mention of the grant of the patent: **25.09.2002**
(21) Application number: 98103825.0
(22) Date of filing: 04.03.1998
(51) Int. Cl.: H01L 29/778, H01L 29/205, H01L 29/15, H01L 21/338, H01L 21/20

(54) **Field-effect transistor**
Feldeffekttransistor
Transistor à effet de champ

(30) Priority: 05.03.1997 JP 5061897
(43) Date of publication of application: 09.09.1998
(73) Proprietor: MATSUSHITA ELECTRIC INDUSTRIAL CO., LTD., Kadoma-shi, Osaka 571 (JP)
(72) Inventor: Tanabe, Mitsuru, Katano-shi, Osaka 576 (JP)
(74) Representative: Grünecker, Kinkeldey, Stockmair & Schwanhäusser Anwaltssozietät

(56) References cited:
- DE-A- 19 606 635
- US-A- 5 550 388
- PATENT ABSTRACTS OF JAPAN vol. 012, no. 481 (E-694), 15 December 1988 -& JP 63 197379 A (NEC CORP), 16 August 1988
- PATENT ABSTRACTS OF JAPAN vol. 013, no. 561 (E-859), 13 December 1989 -& JP 01 233776 A (NEC CORP), 19 September 1989
- PATENT ABSTRACTS OF JAPAN vol. 013, no. 106 (E-726), 14 March 1989 -& JP 63 278277 A (FUJITSU LTD), 15 November 1988
- AUER U ET AL: "INALAS/INGAAS HFET WITH EXTREMELY HIGH DEVICE BREAKDOWN USING AN OPTIMIZED BUFFER LAYER STRUCTURE" PROCEEDINGS OF THE INTERNATIONAL CONFERENCE ON INDIUM PHOSPHIDE AND RELATED MATERIALS, SANTA BARBARA, MAR. 27 - 31, 1994, no. CONF. 6, 27 March 1994, pages 443-446, XP000473915 INSTITUTE OF ELECTRICAL AND ELECTRONICS ENGINEERS
- PATENT ABSTRACTS OF JAPAN vol. 017, no. 249 (E-1366), 18 May 1993 -& JP 04 369842 A (MATSUSHITA ELECTRIC IND CO LTD), 22 December 1992
- PATENT ABSTRACTS OF JAPAN vol. 014, no. 012 (E-871), 11 January 1989 -& JP 01 256176 A (FUJITSU LTD), 12 October 1989
- PATENT ABSTRACTS OF JAPAN vol. 014, no. 396 (E-0970), 27 August 1990 -& JP 02 150038 A (SHARP CORP), 8 June 1990
- HAUPT M ET AL: "GROWTH OF AL0.48IN0.52AS/GA0.47IN0.53AS HETEROSTRUCTURES LATTICE RELAXED ON GAAS AND LATTICE MATCHED ON INP" PROCEEDINGS OF THE EIGHTH INTERNATIONAL CONFERENCE ON INDIUM PHOSPHIDE AND RELATED MATERIALS 1996, SCHWABISCH GMUND, APR. 21 - 25, 1996, no. CONF. 8, 21 April 1996, pages 89-92, XP000634441 INSTITUTE OF ELECTRICAL AND ELECTRONICS ENGINEERS

## Description

The present invention relates to a field effect transistor, and more particularly, it relates to a field effect transistor including a semi-insulating substrate of GaAs, a buffer layer formed on the semi-insulating substrate and a channel layer formed on the buffer layer.

In accordance with the rapidly developing multimedia in recent society, the performance required of mobile communication is now being shifted from transmission/receipt of still images to that of dynamic or semi-dynamic images, and hence, communication for massive data is desired.

However, frequency resources of the band of 0.3 through 3 GHz used by current portable telephones and portable handy phones have already been exhausted, and hence, it is very difficult to use this frequency band in the massive communication for transmitting/receiving dynamic or semi-dynamic images.

Therefore, in the field of the massive communication, usage of a very wide millimeter wave band of 30 GHz through 300 GHz has been examined. The usage of the millimeter wave band requires an active device having a sufficiently high gain and a low noise characteristic in the high frequency region of the millimeter wave band. In order to satisfy this requirement, it is necessary to maximize the composition ratio of In in a channel layer of InGaAs in a heterojunction type field effect transistor.

For this purpose, an HEMT including a buffer layer of an InAlAs layer and a channel layer of an InGaAs layer formed on the buffer layer (hereinafter referred to as the InAlAs/InGaAs-HEMT) has been proposed. Since the composition ratio of In in the channel layer can be set at 0.53 or more in the HEMT having this structure, the HEMT can exhibit good element characteristics and is regarded as a promising device to be used in the millimeter wave band.

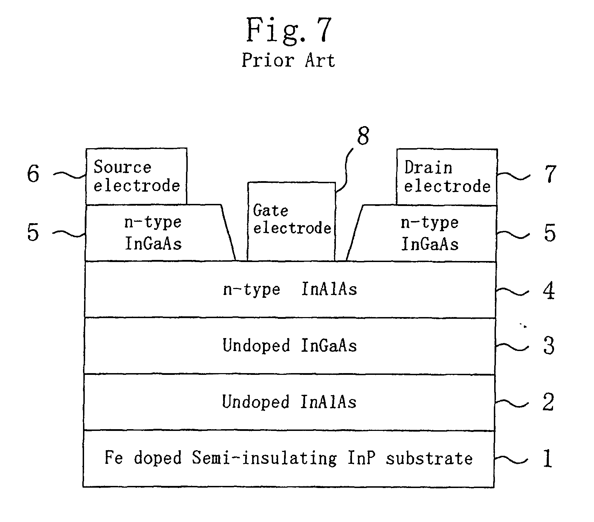

Figure 7 shows the sectional structure of the conventional InAlAs/InGaAs-HEMT, wherein a buffer layer 2 of an undoped InAlAs layer, a channel layer 3 of an undoped InGaAs layer and a Schottky layer 4 of an n-type InAlAs layer are successively formed on a semi-insulating InP substrate 1 doped with Fe. On the Schottky layer 4, a cap layer 5 of an n-type InGaAs layer having a recessed structure is formed. On the cap layer 5, a source electrode 6 and a drain electrode 7 are formed, and a gate electrode 8 is formed in a recessed area of the cap layer 5.

A field effect transistor has a larger gain as a drain conductance (δI_{ds}/δV_{ds}) is smaller. In the conventional InAlAs/InGaAs-HEMT, however, there pronouncedly arises a "kink phenomenon" in which the drain conductance becomes large at a drain voltage as low as approximately 2 V, and hence, its potential cannot be sufficiently exhibited.

This disadvantage is regarded to be derived from an electron trap formed due to crystal defect in the InAlAs layer of the buffer layer 2. Specifically, when a drain voltage is increased, an electron caught by the trap in the buffer layer 2 of the InAlAs layer is excited to work as a conduction electron, so as to rapidly increase a drain current. Thus, the kink phenomenon occurs.

As the countermeasure against the kink phenomenon, various methods have been proposed as follows: In a first method, in formation of the buffer layer 2 through crystal growth, the crystallinity is degraded by decreasing the V/III ratio or setting the growth temperature to be low, thereby forming a further deeper trap. Alternatively, in a second method, the buffer layer 2 is formed in a three-layered structure including a super lattice layer of successively stacked InGaAs layer and InAlAs layer and InAlAs layers formed on and below the super lattice layer, so that occurrence of dislocation from an epitaxial interface (that is, an interface between the semi-insulating InP substrate 1 and the buffer layer 2) can be suppressed.

However, in the first method, it is necessary not only to set the V/III ratio to be high in the channel layer for improving the crystallinity but also to make the V/III ratio continuous between the channel layer and the buffer layer. Therefore, there arises another problem that the efficiency in the crystal growth for forming the channel layer is degraded. Therefore, this method cannot be satisfactory as the method for suppressing the kink phenomenon.

Alternatively, in the second method, the energy band of the InGaAs layer working as a well layer is so low that the InGaAs layer includes a large number of electrons. Therefore, when a drain voltage is applied, a current flows through the InGaAs layer, and hence, the kink phenomenon cannot be sufficiently suppressed by this method.

Patent Abstracts of Japan, Vol. 12, No. 481 (E-694), December 15, 1988, and JP-A-63197379 disclose a field effect transistor comprising a semi-insulating substrate with a buffer layer formed thereon comprising a multilayer film of AllnAs and AlGaAs, or of AlInAs and GaAs, formed on a substrate of InP.

DE-A-19606635 discloses a buffer layer which comprises at least one layer among the group of AlₓIn₁₋ₓP (0.1 ≤ x ≤ 1), GaₓIn₁₋ₓP (0 ≤ x ≤ 1), AlₓGa₁₋ₓAs (0 ≤ x ≤ 1), and AlₓIn₁₋ₓAs (0.5 ≤ x ≤ 1) and comprises an In_{0.52}Al_{0.48}As layer. The buffer layer is formed on a substrate of lnP.

*Patent Abstracts of Japan*, Vol. 14, No. 396 (E-970), 27 August 1990, and JP-A-02150038 disclose a field effect transistor comprising a semi-insulating GaAs substrate and a buffer layer comprising a layer of InAlAs and a layer of GaAs.

US-A-5 550 388 discloses a heterojunction FET including a semi-insulating GaAs substrate, a buffer layer composed of an undoped lnAlAs layer and a barrier layer composed of an undoped AlAs layer and an undoped InAlAs layer, a channel layer composed of an undoped InGaAs layer, and a further N-type InAlAs barrier layer.

*Proceedings of the 8*^{*th*} *International Conference* on *Indium Phosphide and Related Materials 1996*. Schwabisch Gmund, 21-25 April 1996, pages 89-92 (Haupt et al.) discloses a ternary AllnAs/GalnAs hetero-structure. This structure comprises a semi-insulating GaAs substrate and a buffer layer comprising a layer of InAlAs and a layer of InGaAlAs or a layer of InAlAs and a layer of AlGaAs.

Patent Abstracts of Japan, Vol. 13, No. 106 (E-726), March 14, 1989, and JP-A-63278277 disclose a buffer layer of a multilayer film of InAlAs and InAlGaAs formed on a substrate of InP.

It is the object of the invention to provide an improved field effect transistor free from the kink phenomenon that a higher drain voltage rapidly increases a drain current.

This object is achieved with a field effect transistor having the features of present claim 1. A preferred embodiment is the subject matter of claim 2.

The present inventors made various studies on the cause of crystal defect in an InAlAs layer constituting a buffer layer. As a result, it was found that the crystal defect in the InAlAs layer is caused because impurities such as fluorine present in the air are attached onto the surface of a semi-insulating substrate and the attached impurities such as fluorine are diffused into the InAlAs layer constituting the buffer layer during the formation of the buffer layer through the crystal growth. This is not based on the study of a buffer layer adjacent to a channel layer, but is understandable in view of a recent report that the impurities such as fluorine present in the air can be more easily diffused in an InAlAs layer than in another group III-V compound semiconductor layer (*IEICE Technical Report*, Vol. 95, No. 315, October 1995, pages 35-40, (Sato et at.)).

The buffer layer of the invention has a stacked structure including a first layer of an InAlAs layer and a second layer which prevents the impurities such as fluorine attached onto the surface of the semi-insulating substrate from invading the InAlAs layer.

The first field effect transistor of the invention comprises a semi-insulating substrate of GaAs, a buffer layer formed on the semi-insulating substrate and a channel layer formed on the buffer layer, in which the buffer layer has a stacked structure including a first layer of InAlAs and a second layer of a ternary mixed crystal of InGaP or AlGaP.

In the first field effect transistor, the ternary mixed crystal of InGaP or AlGaP has a smaller electronegativity difference as compared with that of the ternary mixed crystal of InAlAs conventionally included in a buffer layer, and hence, electrons are less imbalancedly distributed. Therefore, the impurities such as fluorine are difficult to pass through the second layer of the ternary mixed crystal of InGaP or AlGaP. As a result, the impurities such as fluorine are scarcely diffused in the buffer layer. Accordingly, an electron trap derived from the crystal defect can be scarcely formed in the buffer layer, resulting in preventing the kink phenomenon.

The second field effect transistor of the invention comprises a semi-insulating substrate of GaAs, a buffer layer formed on the semi-insulating substrate and a channel layer formed on the buffer layer, in which the buffer layer has a stacked structure including a first layer of InAlAs and a second layer of a binary crystal of GaP.

In the second field effect transistor, the binary crystal is not a mixed crystal and electrons are not imbalancedly distributed. Therefore, the impurities such as fluorine are difficult to pass through the second layer of the binary crystal of GaP, and hence are scarcely diffused in the buffer layer. Accordingly, an electron trap derived from the crystal defect is scarcely formed in the buffer layer, resulting in preventing the kink phenomenon.

The third field effect transistor of the invention comprises a semi-insulating substrate of GaAs, a buffer layer formed on the semi-insulating substrate and a channel layer formed on the buffer layer, in which the buffer layer has a stacked structure including a first layer of InAlAs and a second layer of a quaternary mixed crystal of InGaAlP.

In the third field effect transistor, since the quaternary mixed crystal of InGaAlP has a smaller electronegativity difference as compared with that of InAlAs, and hence electrons are less imbalancedly distributed. Therefore, the impurities such as fluorine are difficult to pass through the second layer of the quaternary mixed crystal of InGaAlP, and hence are scarcely diffused in the buffer layer. Accordingly, an electron trap derived from the crystal defect is scarcely formed in the buffer layer, resulting in preventing the kink phenomenon.

In each of the first through third field effect transistors, the stacked structure preferably includes a super lattice structure formed by stacking the first layer and the second layer.

In this manner, each of the plural second layers included in the stacked structure can prevent the diffusion of the impurities such as fluorine. As a result, the impurities such as fluorine are more difficult to diffuse in the buffer layer.
Figure 1 is a sectional view of a field effect transistor;
Figure 2(a) is a schematic diagram for illustrating imbalanced distribution of electrons in a ternary mixed crystal of InAlAs having a large electronegativity difference and Figure 2(b) is a schematic diagram for illustrating imbalanced distribution of electrons in a ternary mixed crystal of AlGaAs having a small electronegativity difference;
Figure 3 is a schematic sectional view for illustrating difficulty in diffusion of fluorine into a buffer layer of the field effect transistor ;
Figures 4(a) through 4(c) are sectional views for showing procedures in a method of manufacturing a field effect transistor ;
Figures 5(a) through 5(c) are sectional views for showing other procedures in the method of manufacturing a field effect transistor ;
Figures 6(a) through 6(c) are sectional views for showing still other procedures in the method of manufacturing a field effect transistor of embodiment; and
Figure 7 is a sectional view of a conventional field effect transistor.

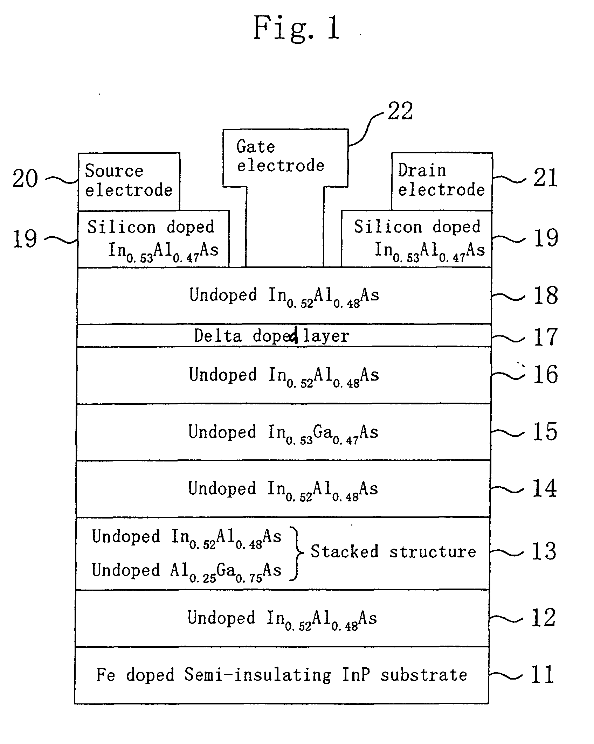

A field effect transistor according to an example to understand the present invention will now be described with reference to Figure 1.

Figure 1 shows the sectional structure of a field effect transistor . As is shown in Figure 1, on an iron doped semi-insulating InP substrate 11, the following layers are successively formed through crystal growth: a first buffer layer 12 of an undoped In_{0.52}Al_{0.48}As layer with a thickness of 100 nm; a second buffer layer 13 having a super lattice structure formed by alternately stacking ten undoped In_{0.52}Al_{0.48}As layers each with a thickness of 10 nm and ten undoped Al_{0.25}Ga_{0.75}As layers each with a thickness of 2 nm; a third buffer layer 14 of an undoped In_{0.52}Al_{0.48}As layer with a thickness of 300 nm; a channel layer 15 of an undoped In_{0.53}Ga_{0.47}As layer with a thickness of 10 nm; a spacer layer 16 of an undoped In_{0.52}Al_{0.48}As layer with a thickness of 3 nm; a delta doped layer 17 of a silicon layer; and a Schottky layer 18 of an undoped In_{0.52}Al_{0.48}As layer with a thickness of 30 nm. On the Schottky layer 18, a cap layer 19 of an n-type In_{0.53}Ga_{0.47}As layer in a recessed structure with a thickness of 50 nm is formed. On the cap layer 19, a source electrode 20 and a drain electrode 21 are formed, and a gate electrode 22 is formed in a recessed area of the cap layer 19.

The delta doped layer 17 is interposed between the spacer layer 16 and the Schottky layer 18 for the following reason A distance between the channel layer 15 and the gate electrode 22 is preferably smaller, but a dose in the channel layer 15 is required to be increased in accordance with the decreased distance in order to attain a predetermined carrier concentration in the channel layer 15. However, when the dose is increased, a drain breakdown voltage can be decreased. Therefore, the delta doped layer 17 is interposed so as to attain the predetermined carrier concentration with decreasing the distance between the channel layer 15 and the gate electrode 22 without decreasing the drain breakdown voltage.

In this manner, the field effect transistor includes, as a buffer layer, the first buffer layer 12 of the InAlAs layer, the second buffer layer 13 including the stacked InAlAs layers and AlGaAs layers and the third buffer layer 14 of the InAlAs layer. In other words, the second buffer layer 13 in the superlattice structure has a stacked structure including the InAlAs layers and the AlGaAs layers instead of the conventionally used stacked structure of InAlAs and InGaAs. Therefore, impurities such as fluorine attached onto the surface of the semi-insulating InP substrate 11 can be difficult to diffuse in the second buffer layer 13 As a result, crystal defect is hardly caused in the second buffer layer 13. The reason will be described in detail below.

The buffer layer includes the first buffer layer 12 of the InAlAs layer, the second buffer layer 13 in the superlattice structure of InAlAs and AlGaAs and the third buffer layer 14 of the InAlAs layer. Instead, the buffer layer can be composed of two layers including a lower buffer layer of an InAlAs layer and an upper buffer layer in the superlattice structure of InAlAs and AlGaAs. Alternatively, the buffer layer can be composed of two layers including a lower buffer layer in the superlattice structure of InAlAs and AlGaAs and an upper buffer layer of an InAlAs layer, or can be composed of merely one buffer layer in the superlattice structure of InAlAs and AlGaAs. Furthermore, the superlattice structure of InAlAs and AlGaAs can be replaced with a simply stacked structure including one InAlAs layer and one AlGaAs layer.

In accordance with the present invention, the buffer layer having the stacked structure of the InAlAs layers and the AlGaAs layers as exemplified above is replaced with a stacked structure including a first layer of InAlAs and a second layer of a ternary mixed crystal of InGaP or AlGaP and the semi-insulating InP substrate is replaced with a semi-insulating GaAs substrate. Furthermore, the stacked structure can then include one first layer and one second layer, or can be in the superlattice structure including plural first layers and plural second layers alternately stacked on one another.

The impurities such as fluorine attached onto the surface of the semi-insulating substrate can hardly diffuse in the buffer layer when the buffer layer has the stacked structure including the first layer of InAlAs and the second layer of the ternary mixed crystal of AlGaAs, InGaP or AlGaP for the following reason:

The electronegativity difference of InAlAs of the first layer is 0.61 eV, while the electronegativity differences of AlGaAs, InGaP and AlGaP of the second layer are 0.18 eV, 0.55 eV and 0.09 eV, respectively, which are very small as compared with that of InAlAs. When the electronegativity difference is small, electrons are less imbalancedly distributed, and hence, impurities such as fluorine are difficult to diffuse. This is for the following reason:

Crystals are bonded with mutually complementing electrons, and atoms bonded by sharing an electron serve as a skeleton of a crystal. In an ionic crystal, the shared electron is imbalancedly distributed toward one of the atoms. Since the size of an atom depends upon spread of electron cloud constituting the atom, an atom including an imbalancedly distributed electron effectively has a larger radius. This also applies to a molecular replaced with an atom.

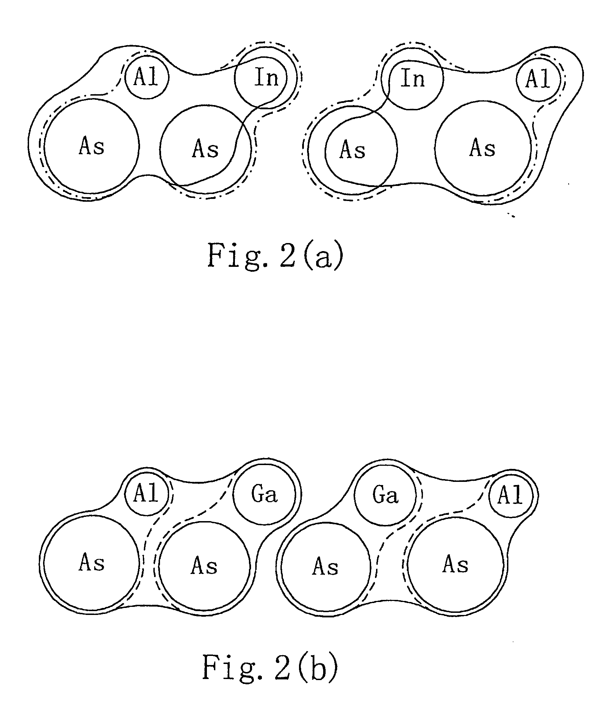

As an index of the imbalanced distribution of an electron, the electronegativity difference is used, and when the electronegativity difference is large, an electron is largely imbalancedly distributed between atoms and between molecules. Figure 2(a) shows the imbalanced distribution of electrons in InAlAs having a large electronegativity difference. As is shown with a solid line, a gap between the mixed crystals of InAlAs is large because the distribution of the electrons is more imbalanced. In Figure 2(a), a dashed line shows the state where the electrons are not imbalancedly distributed. Figure 2(b) shows the imbalanced distribution of electrons in AlGaAs having a small electronegativity difference, and a gap between the mixed crystals of AlGaAs is small because the distribution of the electrons is less imbalanced.

The imbalanced distribution of electrons is regarded to locally decrease a packing density of the atoms. For example, since the electronegativity differences of AlGaAs and InAlAs are 0.18 eV and 0.61 eV, respectively, the local decrease of the packing density is smaller in AlGaAs than in InAlAs. Therefore, the impurities such as fluorine are difficult to diffuse in AlGaAs.

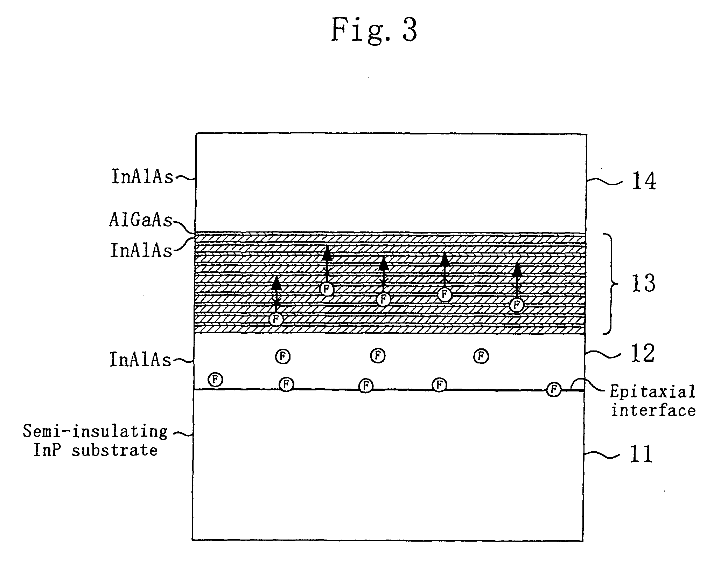

Figure 3 schematically shows a state where fluorine present on an epitaxial interface between the semi-insulating InP substrate 11 and the first buffer layer 12 moves through the second buffer layer 13 toward the third buffer layer 14. As is shown in Figure 3, fluorine is prevented from diffusing in the AlGaAs layer of the second buffer layer 13 and hence scarcely reaches the third buffer layer 14.

In accordance with the invention, the buffer layer has the stacked structure including the first layer of InAlAs and the second layer of the ternary mixed crystal of InGaP or AlGaP, but the stacked structure can be replaced with a stacked structure including a first layer of InAlAs and a second layer of a binary crystal of GaP, or a stacked structure including a first layer of InAlAs and a second layer of a quaternary mixed crystal of InGaAlP.

When the buffer layer has the stacked structure including the binary crystal, electrons are not imbalancedly distributed in the binary crystal because it is not a mixed crystal Therefore, the diffusion of the impurities such as fluorine can be suppressed.

Also, when the buffer layer includes the quaternary mixed crystal, the distribution of electrons is less imbalanced when the mixed crystal has a small electronegativity difference. Therefore, the diffusion of the impurities such as fluorine can be suppressed for the same reason as in the case where the ternary mixed crystal is used. The quaternary mixed crystal of InGaAlP has a small electronegativity difference and hence can suppress the diffusion of the impurities such as fluorine. When the quaternary mixed crystal is used, lattice conformity with the GaAs substrate can be attained by appropriately selecting the composition of the buffer layer.

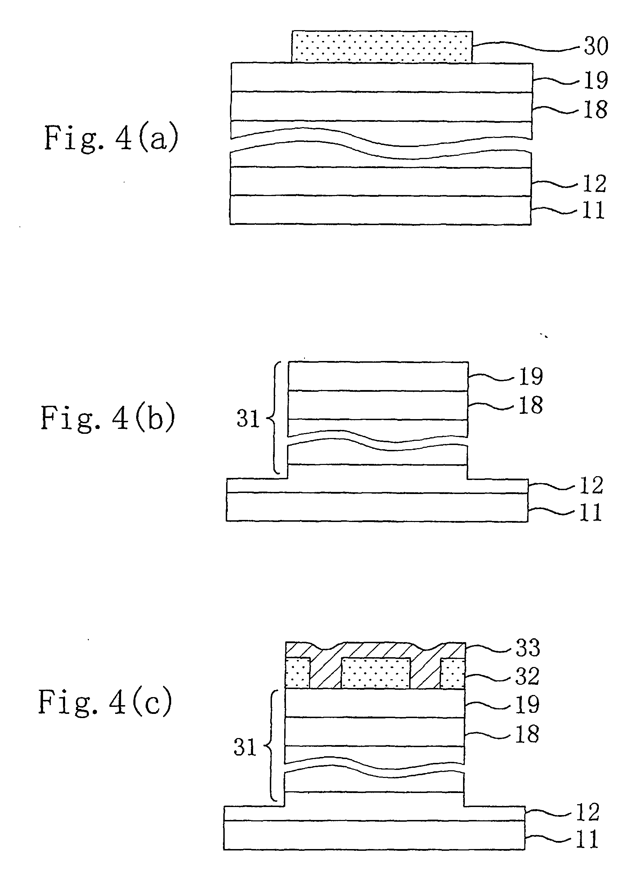

Now, a method of manufacturing a field effect transistor will be described as an example not being part of the invention with reference to Figures 4(a) through 4(c), 5(a) through 5(c) and 6(a) through 6(c).

First, as is shown in Figure 4(a), on the iron doped semi-insulating InP substrate 11, the first buffer layer 12 of the undoped In_{0.52}Al_{0.48}As layer with a thickness of 100 nm, the second buffer layer 13 in the superlattice structure formed by alternately stacking the ten undoped In_{0.52}Al_{0.48}As layers each with a thickness of 10 nm and the ten undoped Al_{0.25}Ga_{0.75}As layers each with a thickness of 2 nm, the third buffer layer 14 of the undoped In_{0.52}Al_{0.48}As layer with a thickness of 300 nm, the channel layer 15 of the undoped In_{0.53}Ga_{0.47}As layer with a thickness of 10 nm, the spacer layer 16 of the undoped In_{0.52}Al_{0.48}As layer with a thickness of 3 nm, the delta doped layer 16 of the silicon layer, the Schottky layer 18 of the undoped In_{0.52}Al_{0.48}As layer with a thickness of 30 nm, and the cap layer 19 of the silicon doped n-type In_{0.53}Ga_{0.47}As layer with a thickness of 50 nm are successively epitaxially grown by the MBE. Then, in a transistor area on the cap layer 19, a first resist pattern 30 is formed.

Next, as is shown in Figure 4(b), the epitaxially grown layers are etched with, for example, a phosphate etchant by using the first resist pattern 30 as a mask, thereby forming a mesa structure body 31 including the epitaxially grown layers. Thereafter, the first resist pattern 30 is removed.

Then, as is shown in Figure 4(c), on the cap layer 19, a second resist pattern 32 having openings respectively corresponding to source and drain regions is formed. A first metal film 33 is then deposited on the entire top surface through vapor deposition of an ohmic metal such as Ni/AuGe/Au.

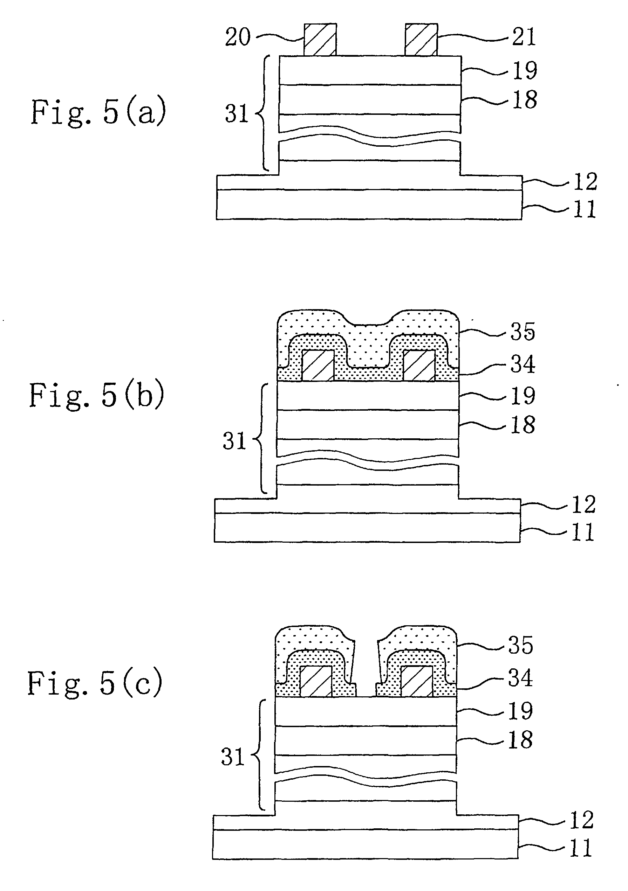

Next, when the second resist pattern 32 is lift off, the source electrode 20 and the drain electrode 21 made from the first metal film 33 are formed on the cap layer 19 as is shown in Figure 5(a).

Then, as is shown in Figure 5(b), after a first resist film 34 of a resist material sensitive to EB, such as PMMA, is deposited on the cap layer 19, a second resist film 35 of a resist material similarly sensitive to EB, such as P(MMA/MAA) (poly(methylmethacrylate-co-methcacrylate acid), is deposited on the first resist film 34.

Next, as is shown in Figure 5(c), the second resist film 35 is exposed with EB and developed, thereby forming a space pattern of, for example, 0.5 µm. Furthermore, the first resist film 34 is irradiated with EB, thereby forming a space pattern of, for example, 0.1 µm in the first resist film 34.

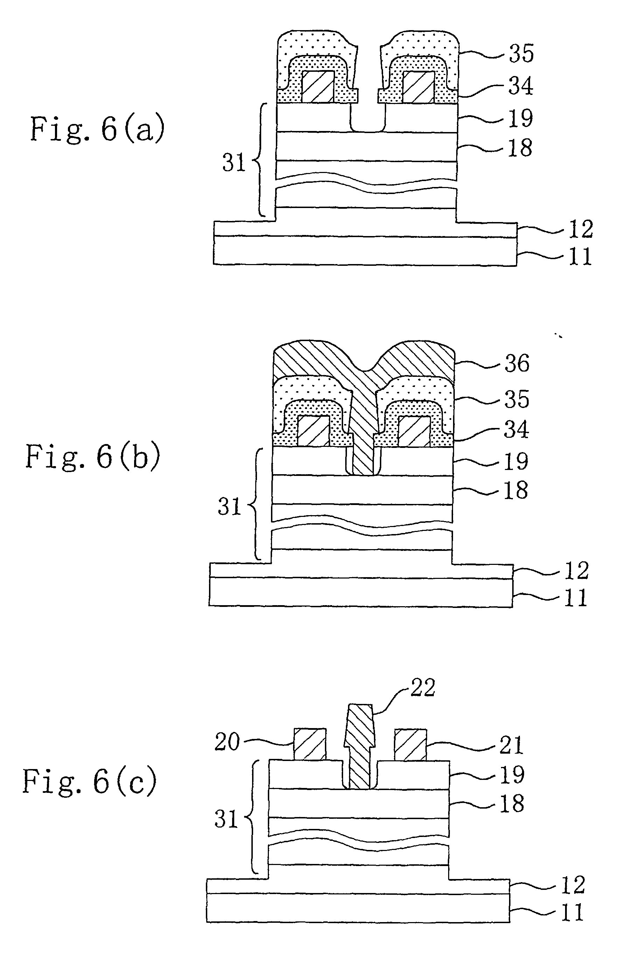

Then, the cap layer 19 is recess-etched with a phosphate etchant, thereby forming the recessed area in the cap layer 19 as is shown in Figure 6(a).

Then, as is shown in Figure 6(b), a gate metal such as Ti/Pt/Au is vapor-deposited on the entire top surface of the second resist film 35, thereby forming a second metal film 36. The first resist film 34 and the second resist film 35 are then lift off. Thus, the source electrode 20 and the drain electrode 21 are exposed and the gate electrode 22 made from the second metal film 36 is formed in the recessed area of the cap layer 19 as is shown in Figure 6(c).

## Claims

1. Field-effect transistor comprising:
a semi-insulating substrate of GaAs, a buffer layer formed on said semi-insulating substrate and a channel layer formed on said buffer layer,
said buffer layer having a stacked structure including a first layer of InAlAs and a second layer,
**characterised in that** said second layer is formed of InGaP, AlGaP, GaP, or InGaAlP.

2. Field-effect transistor according to claim 1, wherein said stacked structure includes a super lattice structure comprising said first layer and said second layer and being formed by alternately stacking layers made of the first layer material and of the second layer material, respectively.

## Patentansprüche

1. Feldeffekttransistor, der umfasst:
ein halbisolierendes Substrat aus GaAs, eine auf dem halbisolierenden Substrat gebildete Pufferschicht und eine auf der Pufferschicht gebildete Kanalschicht,
wobei die Pufferschicht eine geschichtete Struktur aufweist, die eine erste Schicht aus InAlAs und eine zweite Schicht umfasst, **dadurch gekennzeichnet, dass** die zweite Schicht aus InGaP, AlGaP, GaP oder InGaAlP gebildet wird.

2. Feldeffekttransistor nach Anspruch 1, wobei die geschichtete Struktur eine Übergitterstruktur einschließt, die die erste Schicht und die zweite Schicht umfasst und durch abwechselndes Aufeinanderschichten von Schichten gebildet wird, die aus dem Material der ersten Schicht bzw. dem Material der zweiten Schicht bestehen.

## Revendications

1. Transistor à effet de champ comprenant :
un substrat semi-isolant en GaAs (arséniure de gallium), une couche intermédiaire formée sur ledit substrat semi-isolant et une couche de canal formée sur ladite couche intermédiaire,
ladite couche intermédiaire possédant une structure superposée incluant une première couche d'InAlAs (arséniure d'indium dopé à l'aluminium) et une seconde couche, **caractérisé en ce que** ladite seconde couche est formée d'InGaP (phosphure d'indium et de gallium), d'AlGaP (phosphure de gallium dopé à l'aluminium), de GaP (phosphure de gallium) ou d'InGaAlP (phosphure d'indium et de gallium dopé à l'aluminium).

2. Transistor à effet de champ selon la revendication 1, dans lequel ladite structure superposée inclut une structure de super-réseau cristallin comprenant ladite première couche et ladite seconde couche et formée en superposant alternativement des couches en matériau de la première couche et en matériau de la seconde couche, respectivement.
